# EUROPEAN PATENT SPECIFICATION

(11) **EP 2 457 423 B1**
(45) Date of publication and mention of the grant of the patent: **05.07.2017**
(21) Application number: 10802506.5
(22) Date of filing: 20.07.2010
(51) Int. Cl.: F01N 13/00, H05K 7/20, H01L 23/34, H01L 23/367

(54) **LOCAL THERMAL MANAGEMENT**
LOKALE WÄRMEVERWALTUNG
GESTION THERMIQUE LOCALE

(30) Priority: 20.07.2009 NO 20092713
(43) Date of publication of application: 30.05.2012
(73) Proprietor: Sinvent AS, 7465 Trondheim (NO)
(72) Inventor: LARSSON, Andreas, N-0314 Oslo (NO)
(74) Representative: Heggstad, Jon Dagson
(86) International application number: PCT/NO2010/000288
(87) International publication number: WO 2011/010936

(56) References cited:
- WO-A1-01/06246
- WO-A2-2007/087090
- JP-A- 8 220 048
- JP-A- H0 552 143
- US-A- 6 058 012
- US-A1- 2006 102 353
- US-A1- 2007 296 071
- US-A1- 2009 024 969
- SARVAR F. ET AL: 'Thermal Interface Materials - A Review of the State of the Art' 2006 ELECTRONICS SYSTEMINTEGRATION TECHNOLOGY CONFERENCE DRESDEN GERMANY, pages 1292 - 1302, XP031462449

## Description

The present invention concerns an apparatus and a method for thermal management of a component in a first region, which may be hot or cold compared to a surrounding second region.

### BACKGROUND OF THE INVENTION

There is sometimes a need to cool or heat a device or component locally in a first region which is hotter or cooler than the temperature in a second, ambient region. Some examples are:
- Particle detection by thermophoresis, where particles, e.g. soot, is deposited on a sensor area when the sensor area is significantly cooler than the surrounding hot fluid flow. Applications include detecting soot in the exhaust gases from a combustion engine or from a combustion oven.
- Regenerating a sensor by burning off deposited particles.
- Cooling electronic and other components for a proper and reliable operation in hot environments, e.g. in wells for production of hydrocarbons or geothermal industry.
- Heating a frozen, movable component, in particular where use of electricity for heating is impractical or prohibited.

It is noted that the above applications may involve thermal management in corrosive, hot and/or otherwise harsh or hostile environments.

An example is drawn from the automotive industry and a project to detect soot particle content in the exhaust gas system of diesel engines (Soot sensors for a healthy environment, SootSens, MNT ERA-Net TRANSNATIONAL CALL 2007). The sensor concept is based on the physical phenomenon thermophoresis. Thermophoretic deposition of particles in a gas is driven by the temperature gradient (Messerer et. al. "Thermophoretic deposition of soot aerosol particles under experimental conditions relevant for modern diesel engine exhaust gas systems", Journal of Aerosol Science, April 2003). The theory states that soot particles are drawn towards colder regions in the gas and finally deposit onto a cold surface, if present. Soot deposited on top of a common finger electrode structure changes the electrical resistance of the electrode, which can be monitored, i.e. soot can be detected. This information can be used in a monitoring system to indicate when a filter is full or damaged and regeneration or replacement is required.

The particle velocity for thermophoresis is directly proportional to the temperature gradient between the hot gas and the cooler sensor area. Thus, a high temperature gradient in the sensor vicinity is believed to increase the sensitivity of a sensor in a low soot concentration environment, as more soot will be deposited. Preliminary results show that a temperature difference of 50-70°C between the sensor surface and the hot gases is sufficient for a thermophoresis based soot sensor to work.

The exhaust pipe may provide an excellent heat sink for a thermophoresis based sensor disposed in the hotter gases within the pipe. However, a reasonably good thermal conductor e.g. a alumina sensor substrate, when inserted through the exhaust wall and directly exposed to the exhaust gas flow, will typically not transfer sufficient heat for soot sense applications based on thermophoresis. In other words, an alumina sensor substrate quickly accumulates heat from the ambient gas, and approach the gas temperature. The resulting temperature gradient within the substrate will be sharp and located close to the exhaust pipe wall. Hence the remaining parts, including the sensor surface at the substrate tip inside the pipe and away from the pipe wall, will have a temperature very close to that of the gas. Thus, even when the sensor substrate is a reasonably good heat conductor, and even if the temperature difference between the exhaust gases and the exhaust pipe is considerably greater than the 50-70°C required for a thermophoresis based sensor to work, the substrate alone will not provide the cooler surface required for such a sensor.

Insulating parts of the substrate from direct exposure to the gas has shown that the temperature gradient within the alumina extends further away from the exhaust pipe wall. i.e. the sensor surface temperature, at the tip, will be reduced. Conventional heat insulation, e.g. steel wool wound around the sensor substrate (i.e. thermal interconnector), has been shown inadequate to maintain a 50-70°C temperature difference between the hot exhaust gas and the sensor area. The required volume of insulation for sufficient performance is significant. An exhaust pipe has limited space available for a sensor application, hence bulky insulation or cooling equipment will simply not be an option.

Thermophoresis can also be used to detect particle contents in the exhaust gases from a combustion oven, as it is a suitable method to detect low particle concentrations in hot gases. In this application, the exhaust gas temperature may exceed 300°C, and the pipe diameter and other dimensions are generally larger than in the previous example. Still, a sensor needs to be put into the hot gases away from a colder exhaust conduit. The sensor must provide a cool surface, and there is still limited space available for any bulky insulation or cooling equipment. Local active cooling may be expensive and/or inadequate with respect to size requirements.

In another example, thermal management can be employed in the process to regenerate the sensor surface from the above examples: When soot deposits, the soot sensor looses its sensitivity. However, reliable and accurate measurements over time may be required in applications such as long time monitoring of a particular filter status, for monitoring a diesel engine exhaust gas system, etc. Particles can be removed by cremation, i.e. by increasing the sensor surface temperature to transform the particles to combustion gases and ash, e.g. to a surface temperature above 600°C. Conducting the required power through the sensor and/or sensor electronics may burn off sensor elements and/or wiring as well as soot and other particles.

Thus, a temperature increase in the sensor area is required without increasing the temperature in the wires above the melting point of the electrical insulation materials, the bonding etc. In other words, a substantial amount of the supplied heat energy should be provided by a secondary heat path. Additional heat may be supplied locally through the sensor area, as long as it does not exceed the limits for the sensor and/or the electronics, etc.

Another example involve a movable component that needs a temporary motion in an icy environment, e.g. a ship in the Arctic, where sea spray and temperatures below 0°C build layers of ice on rigging and deck equipment.

Ice will hamper movable parts from operating properly. Water has a considerable heat capacity, impeding the progress of melting. Obviously, the melting process can be speeded up and energy consumption held at a minimum by heating the components locally. This can be achieved by local thermal management, in particular by heating the component to a temperature above 0°C while the surrounding ice is exposed to minimal heat transfer from the supplied power. Electric resistors of various forms are typically used for such local heating applications. An electric resistor emits heat when an electric current passes though, and can generally be adapted to the application at hand in an easy manner. However, special care must be taken when using electricity in applications like this. Among other things, proper electric insulation must be provided to ensure that no part of the electric circuit comes into contact with water at any point in time. In areas with explosion hazard, use of electricity may be prohibited.

In other words, thermal management of the component from a region outside the cold area, including the ice, without use of electricity, will be highly advantageous for this type of application. In particular, local thermal management with a minimum of power losses will be advantageous.

Lab-on-a-chip applications were local precision heating without electrical connection or where space is limited is also an area of application for this invention.

Document US 2006/0102 353 A shows an example of thermal management of a component in a downhole tool for drilling . Thus, an objective of the present invention is to provide thermal management of a component mounted on an interconnector, where the component, e.g. a sensor or a moving part, is disposed in a first thermal region and thermally connected to a second thermal region by the interconnector.

Further objectives include provision for a simple and cost effective design with focus on reliable and durable operation, with the option to easily miniaturize the thermal management system.

Areas of use include providing efficient particle deposition by thermophoresis and other applications where a comparatively small region it to be managed thermally with respect to its surroundings.

### SUMMARY OF THE INVENTION

This objective is achieved by providing an apparatus and a method for thermal management of a component in a first region, wherein an interconnector connects the component thermally to a second heat region, wherein a thermally conducting heat shield encloses the interconnector from a position within the first region, in close proximity to the component, to the second region, and that at least one heat unit is thermally connected to at least one of the heat shield and the interconnector within the second region.

The basic idea behind the invention is to utilize the relative thermal resistance of different parallel heat paths.

When heat enters the heat shield from a hot surrounding first region, e.g. hot gas, the heat shield conducts heat more efficiently than the medium encapsulated by the heat shield. Thus, the heat tends to follow the path provided by the heat shield i.e. the path with low thermal resistance, rather than dissipating through it and enter the encapsulated region, where an interconnector is to be kept at a lower temperature. The heat from the heat shield is dissipated through a proper heat unit, in this case a heat sink, at a suitable location in connection with the second region, rather than heating the encapsulated region. Thus, the need for bulky insulation is significantly reduced.

When a heat unit in the form of a heat source provides the thermally conductive heat shield with heat, e.g. for cremation of deposited particles as discussed above, heat isconducted through the heat shield to the component location. In this case, heat is also radiated from the heat shield to the surrounding environment, and in one embodiment, the top face of the heat shield can have a parabolic shape that concentrates radiation from the heat shield to the sensor area, heating the sensor surface. It is noted that in a practical soot sensor, all or part of the heat required to burn off soot may be provided through the interconnector, and that providing heat through the heat shield in the above example is for illustrative purposes only.

Another way of heating the component within the first region, is by connecting a heat source in the second region to the interconnector, which conducts heat to the component. This assumes that the thermal conductivity of the interconnector is sufficient to provide enough energy transport to the component. In this case, the heat shield will shield the interconnector from the first region, which is now a cold region relative to the hotter second region. This may be an energy efficient way of heating a component to a desired temperature, e.g. the movable part encapsulated in ice or burning soot off of a sensor surface as discussed above. Further, as heat is transferred as heat, there is no need for electrical heating in the first region, with its adherent limitations, as mentioned previously.

When the heat shield is disposed in a first region which is colder than the second region, e.g. when the heat shield is enclosed in ice, heat emanated from a hot interconnector enters the heat shield from the inside. If the heat shield conducts heat more efficiently than the surrounding medium, e.g. ice, the heat is again conducted to a proper heat sink. In this case the heat could be used to heat the interconnector, rather than, for example, unnecessary melting of the ice.

These and other features and benefits are properly disclosed in the accompanying claims.

### BRIEF DESCRIPTION OF THE DRAWINGS

The invention will be better understood from the following detailed description with reference to the accompanying drawings, where like numerals refer to similar, but not necessarily equal, parts throughout the several figures, and where:
Figure 1 is a perspective view of a heat shield and interconnector assembly
Figure 2 indicates the interior of the assembly in fig. 1.
Figure 3a,b are side views of the assembly in fig. 1, seen from angles 90° apart
Figure 4 is a top view of the assembly of the previous figures
Figure 5 shows a cross section taken along the line A-A in fig. 4
Figure 6 a-c are schematic views of a first embodiment
Figure 7 a-c are schematic views of a second embodiment
Figure 8 is a schematic view showing convection in a heat shield
Figure 9a, b are schematic views of a third embodiment
Figure 10 is a schematic view of an embodiment with extra support
Figure 11 is a perspective view of the embodiment in Figure 10
Figure 12 is an enlarged, cross sectional view of a detail on Figure 2

### DETAILED DESCRIPTION

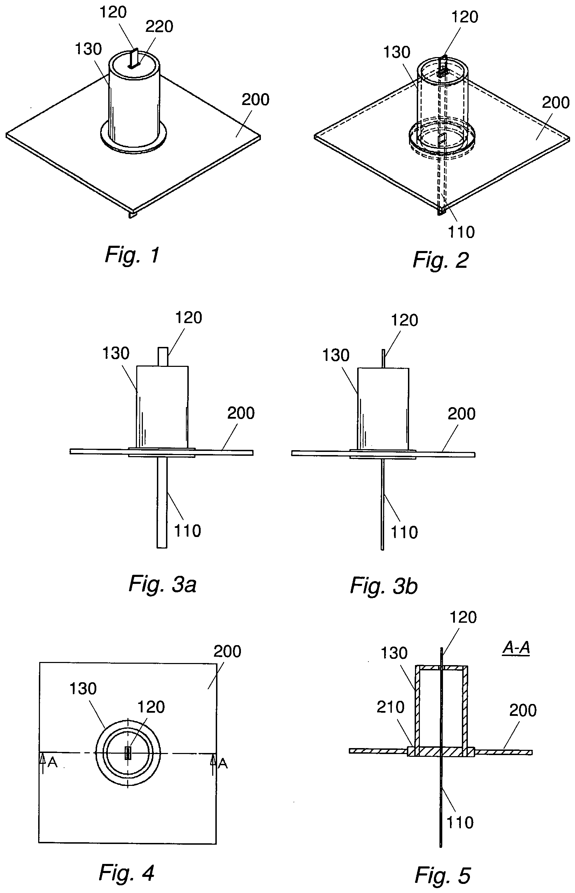

Figures 1-5 illustrates preferred embodiments of the present disclosure through several views and cross sections viewed from different angles. The component to be thermally managed is represented by 120, and is mounted on or is a part of an interconnector 110. A thermally conducting heat shield 130 encloses the interconnector 110 up to the component 120 that is required to be exposed to a first region. As used herein, the terms first and second region refer to distinct thermal regions, i.e. regardless whether the regions are otherwise connected and regardless of their other properties.

The part referenced by 220 in figure 1 is a fitting, which can either be a thermal conductor or insulator in the context of thermal management and this disclosure. The main purpose for fitting 220 is to mechanically connect the interconnector 110 to the heat shield 130 and/or provide a seal, separating the first region from the interior of the heat shield. In other contexts, the parts represented by numeral 220 throughout the description, claims and drawings have different functions like; fastening or sealing one part to another, e.g. the heat shield 130 to the interconnector 110 Parts, e.g. 220, can be provided to allow for use of materials with different coefficients of thermal expansion (CTE), and for this purpose be, e.g., an elastomer, a sheet of ceramic paper or a small gap. In general, an insulator, or more precisely an element with a low thermal conductivity, may intentionally be inserted between elements to reduce thermal flow e.g. between the heat shield and the interconnector. However, for simplicity, parts acting as thermal resistors in the context of thermal management are here collectively referenced by numeral 210, regardless of their other functions as adhesives, sealants, adaptors for thermal expansion, lids, other structural elements, etc.

It is noted that impact from CTE mismatch will decrease with a decrease in contact area and length. In the present disclosure, the contact area at the interconnection between the heat shield and the component and/or the interconnector can be small or even omitted from the design. The present invention therefore provides a viable way to minimizing or eliminating CTE mismatch.

The first region can be the interior of a conduit or container for a hot or cold flowing or stationary fluid, in which the component 120 is inserted. For illustrative purposes, the figures show a part of a conduit wall 200 separating the first and second thermal regions. Thus, in the figures, the first region is simply the region above the conduit wall 200, and the second region is the area below the conduit wall 200. However, it should be understood that the component 120 to be thermally managed can be enclosed in a solid, e.g. ice or an alloy, in which case there is no need for a physical wall 200. Further, a physical container or conduit would obviously have some structured design and a temperature gradient separating the first and second regions. As this structure and temperature gradient are irrelevant for the present disclosure, they are simply not shown.

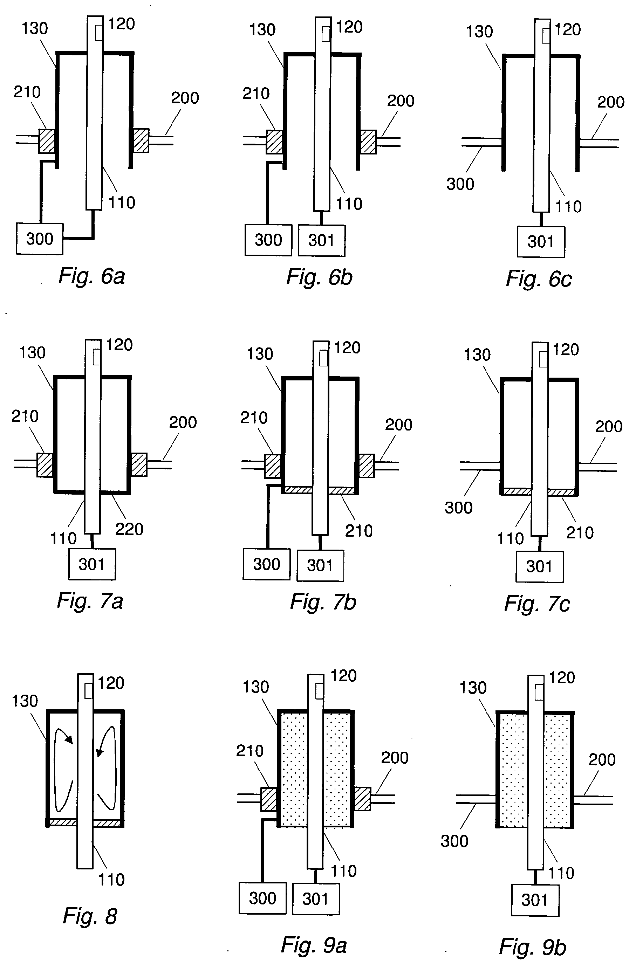

Figures 6a-c is schematic views of various embodiments, in which the heat shield 130 is open towards the second region. This is mainly meant to indicate that the ambient fluid can provide sufficient thermal insulation between the interconnector 110 and the heat shield 130. In some applications, this ambient fluid will be air or some other gas. However, any ambient fluid could enter the cavity within the open heat shield in figures 6a-c. For example, in the introduction chapter, an oil well application is mentioned, where a component 120 might be disposed in fluid, represented by the first region, having a pressure of several hundred bars. A typical well tool, represented by the second region, may be filled with a clean liquid, e.g. mineral oil. The clean mineral oil will be mechanically isolated from the surrounding oil well, while the pressure can be, but does not have to be be balanced to that of the surrounding fluids. The liquid within the well tool (second region) will have low compressibility and is expected to provide sufficient thermal insulation for the purposes of the concrete application of the present invention.

In figure 6a, the interconnector 110 and heat shield 130 share a heat unit 300, which may be a heat sink or a heat source depending on the application; heating or cooling the component. A thermal resistor 210 is shown between the heat shield 130 and the conduit wall 200, to indicate that the heat may not flow effectively to the conduit wall 200 in all applications. In fact, the conduit wall may not even exist in all applications. This is the case when, for example, a heat shield is enclosed in ice.

For clarity, the thermal resistor 210/fitting 220 shown in fig 1 and several other thermal resistors and/or fittings are omitted from the schematic views in fig 6a-9b. However, in a physical embodiment, parts may be joined by an adhesive or a mechanical connection, or require some means to allow for differences in thermal expansion coefficient, both of which change the thermal resistance. See also the description of fig 1.

Figure 6b illustrates a combination in which the interconnector 110 and heat shield 130 are connected to separate heat units 300 and 301. Either of the heat units 300, 301 may be a heat sink or a heat source. Thus, in the example of a movable frozen part in an icy environment, from the introduction chapter, the heat unit 301, connected to the interconnector 110, would be a heat source providing heat to melt the ice around the component 120, and the heat unit 300, connected to the heat shield 130, would be a heat sink to dissipate excess heat, to prevent unintentional and energy consuming melting of ice. If the medium or lack of medium (vacuum) enclosed by the heat shield 130 is transparent to heat radiation (IR), the interior surfaces may be surface treated to reduce heat from being transferred by radiation between them, e.g. polish them to be reflective.

Figure 6c shows a special case of figure 6b, in which the conduit wall 200 doubles as a heat unit 300 for the heat shield 130. In the example with a soot sensor from the introduction chapter, the component 120 would be the sensor area required to be kept 50-70°C below the ∼300°C of the exhaust gases. The first region would be the interior of the exhaust pipe, or strictly speaking, the region where the sensor element 120 is inserted into the gas flow, some distance away from the exhaust pipe wall. The second region would be the general region from the exhaust pipe and radially outwards from it. Thus, in this example, the heat unit 301 would be a heat sink to cool the component 120 rather than a heat source to heat the component as in the previous example. The exhaust pipe, represented by the conduit wall 200, may be an excellent heat sink 300 for the heat shield 130 because
a) it typically has a temperature well below the exhaust gas temperature, e.g. 120°C vs the first regions 300°C.
b) the exhaust pipe has a large heat capacity compared to the sensor assembly 110, 120.
c) the heat from the exhaust pipe 200, 300 is readily dissipated into the second region, e.g ambient air and nearby metallic parts.

Figures 7a-c show configurations similar to the ones in figures 6a-c respectively, but where the heat shields in figure 7 are closed towards the second region. Typically the interior is escaped to generate a substantially lower pressure, or "vacuum". The walls inside the cavity are typically polished to be reflective. Both the vacuum and the reflective surfaces provide a reduction of heat transfer between the heat shield and the interconnector.

In particular, figure 7a illustrates a configuration with low thermal resistance between the interconnector 110 and the heat shield 130, whereas figures 7b and 7c show a thermal resistor or insulator between the interconnector 110 and the heat shield 130. As noted, a fitting 220 or a thermal resistor or insulator 210 may be present between the interconnector and heat shield in the upper part of the schematic views, including figures 6a-9b. Such fittings, resistors or insulators are merely not shown in the schematic figures.

As discussed in connection with figure 6, the heat shield can be filled with a gas or a liquid. Figure 8 is intended to illustrate that the fluid can be circulated within the cavity of the heat shield 130 when required. The circulation may be provided by a pump (not shown) circulating fluid, e.g. a fan circulating air in an open configuration as shown in figs 6a-c or a pump circulating a liquid in a closed configuration as shown in figs 7a-c. Boundary conditions at the interconnector 110 and heat shield 130 can also cause natural convection in the cavity, When the configuration is closed, it is important that too much heat does not accumulate within the circulating fluid. Hence, an external heat sink would typically be provided to cool the circulating fluid as it passes the bottom lid in figure 8, and the bottom wall would preferably be good heat conductor rather than the insulator indicated in figure 8.

It should also be noted that the circulation may be in the opposite direction of the one that shown in figure 8, i.e. into the cavity adjacent the interconnector 110 and in the outward direction along the heat shield 130.

Figures 9a, b illustrates that the interior of the heat shield can be a medium or combination of any media of any phase, including solid or granular media. The requirement for a solid medium may be determined by a structural mechanics point of view, e.g. to withstand extensive mechanical loads. For example, if the temperature in the first region is time dependent or transient, the interior can be filled with a mechanically strong solid or granular medium with a large heat capacity, e.g. titanium. In this way, a large, but short temperature change in the first region will only slightly affect the overall temperature of the encapsulated medium.

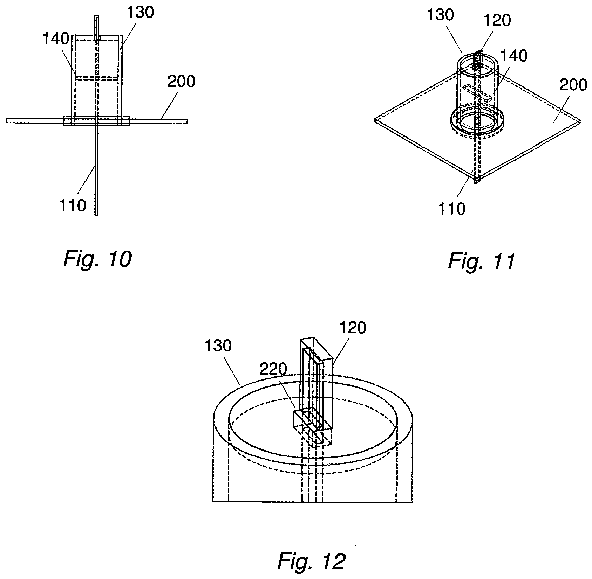

Figures 10 and 11 show the embodiment of figures 1-5 with a support 140 disposed between the interconnector 110 and the heat shield 130 in order to provide mechanical stability or rigidity to the structure. It is readily understood that several such supports may be disposed if needed.

Figure 12 is an enlarged view of the top of the heat shield/interconnector assembly. In particular, the fitting 220 between the interconnector 110 and the heat shield 130 is apparent. Also, the reference numeral 120 points to a sensor assembly covered by an extension of the shield 130. In some applications, the sensing surface can be in contact with the gases. In other applications, the component, including a sensor, may be entirely encapsulated. It should be noted that any sensor 120 may be protected by a cover and/or an extension of the shield 130 in this manner.

If the temperature at the component is requested to be stable, a medium with a large heat capacity, will act as a method to control and reduce temperature fluctuations within the component.

From the discussion above, it should be clear that, any combination of a heat shield 130 open or closed to a surrounding second region, filled with air, another gas, liquid, a solid or granular material can be used in different applications. Any of these combinations can further be configured with a heat shield 130 connected to a heat sink or heat source 300, 301. The heat sink 300, 301 may be, but does not have to be, the heat sink 300, 301 that dissipate heat from an interconnector 110, or heat source 300, 301 that provide heat to an interconnector 110 and/or a heat shield 130. Any of these variants may, in turn, be combined with any interconnector 110 and component 120 which is to be thermally managed. Further, the medium within the heat shield 130 is generally chosen to avoid heat transfer between the interconnector 110 and the heat shield 130, but may be chosen to inhibit thermal exchange between the interconnector 110 and the heat shield 130. Elements 210 and 220 with a different thermal conductivity than adjacent elements may be required between any elements of the structure, e.g. to compensate for differences in thermal expansion. Surface treatment may be used to minimize heat transfer between the interconnector 110 and the heat shield 130 e.g. reflecting surfaces. Obviously, the application determines the exact embodiment of the invention.

Although the present invention has been described in terms of certain preferred embodiments, other embodiments that are apparent to those of ordinary skill in the art are also within the scope of the invention. Accordingly, the scope of the invention is intended to be defined only by reference to the appended claims. While variations have been described and shown, it is to be understood that these variations are merely exemplary of the present invention and are by no means meant to be limiting.

## Claims

1. An apparatus for thermal management of a component (120) within a first region, wherein an interconnector (110) connects the component (120) thermally to a second heat region, **characterized in that**
a thermally conducting heat shield (130) encloses the interconnector (110) from a position within the first region in close proximity to the component (120) to the second region, defining a cavity between the interconnector (110) and the heat shield (130), and that
at least one heat unit (300, 301) is thermally connected to at least one of the heat shield (130) and the interconnector (110) within the second region, and that
one of: i) a conduit wall (200); and ii) a solid, enclosing the component (120), is separating the first and second thermal regions.

2. The apparatus of claim 1, wherein at least one heat unit (300, 301) is a heat sink.

3. The apparatus of claim 1, wherein at least one heat unit (300, 301) is a heat source.

4. The apparatus of claim 1, wherein the interior of the heat shield (130) is in fluid communication with the second region.

5. The apparatus of claim 1, further comprising means for circulating fluid in the cavity between the heat shield (130) and the interconnector (110), whereby heat is removed from the cavity.

6. The apparatus of claim 1, wherein the heat shield (130) has a thermal conductivity greater than the thermal conductivity of the medium inside the heat shield (130).

7. The apparatus of claim 1, further comprising a reflective surface on at least one of the interconnector (110) and heat shield (130).

8. A method for thermal management of a component (120) within a first region, wherein a first heat path (110) connects the component (120) thermally to a second heat region, **characterized by**
providing a second heat path (130) enclosing the first heat path (110) from a position within the first region in close proximity to the thermally managed component (120) to the second region, defining a cavity between the second heat path (130) and first heat path (110), and by
providing a thermal connection between at least one of the first heat path (110) and the second heat path (130) to at least one heat unit (300, 301) within the second region, and by
separating the first and second thermal regions by means of one of: i) a conduit wall (200); and ii) a solid, enclosing the component (120).

9. The method of claim 8, further comprising circulating a fluid in the cavity between the first (110) and second (130) heat paths.

10. The method of claim 8, further using a surface treatment to minimise heat transfer between the heat paths (110, 130).

11. The method of claim 8, further comprising managing the temperature of at least one heat unit (300, 301).

## Patentansprüche

1. Vorrichtung zur Wärmeverwaltung einer Komponente (120) innerhalb eines ersten Bereichs, wobei ein Verbinder (110) die Komponente (120) thermisch mit einem zweiten Wärmebereich verbindet,
**dadurch gekennzeichnet, dass**
ein wärmeleitendes Wärmeschild (130) den Verbinder (110) von einer Position innerhalb des ersten Bereichs in unmittelbarer Nähe zu der Komponente (120) zu dem zweiten Bereich umgibt, einen Hohlraum zwischen dem Verbinder (110) und dem Wärmeschild (130) definierend, und dass
wenigstens eine Wärmeeinheit (300, 301) thermisch mit wenigstens einem von dem Wärmeschild (130) und dem Verbinder (110) innerhalb des zweiten Bereichs verbunden ist und dass
eines von: i) einer Leitungswand (200) und ii) einem Festkörper, der die Komponente (120) umgibt, die ersten und zweiten Wärmebereiche trennt.

2. Vorrichtung nach Anspruch 1, wobei wenigstens eine Wärmeeinheit (300, 301) eine Wärmesenke ist.

3. Vorrichtung nach Anspruch 1, wobei wenigstens eine Wärmeeinheit (300, 301) eine Wärmequelle ist.

4. Vorrichtung nach Anspruch 1, wobei der Innenraum des Wärmeschilds (130) in Fluidverbindung mit dem zweiten Bereich steht.

5. Vorrichtung nach Anspruch 1, die ferner Mittel, um ein Fluid in dem Hohlraum zwischen dem Wärmeschild (130) und dem Verbinder (110) zirkulieren zu lassen, umfasst, wobei Wärme aus dem Hohlraum entfernt wird.

6. Vorrichtung nach Anspruch 1, wobei das Wärmeschild (130) eine Wärmeleitfähigkeit größer als die Wärmeleitfähigkeit des Mediums innerhalb des Wärmeschilds (130) hat.

7. Vorrichtung nach Anspruch 1, die ferner eine reflektierende Oberfläche auf wenigstens einem von dem Verbinder (110) und dem Wärmschild (130) umfasst.

8. Verfahren zur Wärmeverwaltung einer Komponente (120) innerhalb eines ersten Bereichs, wobei ein erster Wärmeweg (110) die Komponente (120) thermisch mit einem zweiten Wärmebereich verbindet, **gekennzeichnet durch**:
Bereitstellen eines zweiten Wärmewegs (130), der den ersten Wärmeweg (110) von einer Position innerhalb des ersten Bereichs in unmittelbarer Nähe zu der wärmeverwalteten Komponente (120) zu dem zweiten Bereich umgibt, einen Hohlraum zwischen dem zweiten Wärmeweg (130) und dem ersten Wärmeweg (110) definierend, und durch
Bereitstellen einer thermischen Verbindung zwischen wenigstens einem von dem ersten Wärmeweg (110) und dem zweiten Wärmeweg (130) und wenigstens einer Wärmeeinheit (300, 301) innerhalb des zweiten Bereichs und durch Trennen der ersten und zweiten Wärmebereiche mittels einem von: i) einer Leitungswand (200) und ii) einem Festkörper, der die Komponente (120) umgibt.

9. Verfahren nach Anspruch 8, das ferner umfasst, dass ein Fluid in dem Hohlraum zwischen den ersten (110) und zweiten (130) Wärmewegen zirkulieren kann.

10. Verfahren nach Anspruch 8, das ferner eine Oberflächenbehandlung verwendet, um eine Wärmeübertragung zwischen den Wärmewegen (110, 130) zu minimieren.

11. Verfahren nach Anspruch 8, das ferner ein Verwalten der Temperatur von wenigstens einer Wärmeeinheit (300, 301) umfasst.

## Revendications

1. Appareil de gestion thermique d'un composant (120) dans une première région, dans lequel une interconnexion (110) connecte le composant (120) thermiquement à une seconde région de chaleur, **caractérisé en ce que**
un bouclier thermique thermoconducteur (130) enserre l'interconnexion (110) d'une position située dans la première région à proximité étroite du composant (120) à la seconde région, définissant une cavité entre l'interconnexion (110) et le bouclier thermique (130), **en ce que** :
au moins une unité thermique (300, 301) est thermiquement connectée à au moins l'un(e) du bouclier thermique (130) et de l'interconnexion (110) dans la seconde région et **en ce que** :
l'un(e) i) d'une paroi de conduite (200) ; et ii) d'un solide enserrant le composant (120) sépare la première et la second région thermique.

2. Appareil selon la revendication 1, dans lequel au moins une unité thermique (300, 301) est un puits de chaleur.

3. Appareil selon la revendication 1, dans lequel au moins une unité thermique (300, 301) est une source de chaleur.

4. Appareil selon la revendication 1, dans lequel l'intérieur du bouclier thermique (130) est en communication fluidique avec la seconde région.

5. Appareil selon la revendication 1, comprenant en outre des moyens pour faire circuler du fluide dans la cavité entre le bouclier thermique (130) et l'interconnexion (110), en sorte que de la chaleur soit éliminée de la cavité.

6. Appareil selon la revendication 1, dans lequel le bouclier thermique (130) a une conductibilité thermique supérieure à la conductibilité thermique du milieu à l'intérieur du bouclier thermique (130).

7. Appareil selon la revendication 1, comprenant en outre une surface réfléchissante sur au moins l'un(e) de l'interconnexion (110) et du bouclier thermique (130).

8. Procédé de gestion thermique d'un composant (120) dans une première région, dans lequel un premier trajet de chaleur (110) connecte le composant (120) thermiquement à une seconde région de chaleur, **caractérisé par** :
la fourniture d'un second trajet de chaleur (130) enserrant le premier trajet de chaleur (110) d'une position dans la première région à proximité étroite du composant thermiquement géré (120) à la seconde région, définissant une cavité entre le second trajet de chaleur (130) et le premier trajet de chaleur (110),
la fourniture d'une connexion thermique entre au moins l'un du premier trajet de chaleur (110) et du second trajet de chaleur (130) à au moins une unité thermique (300, 301) dans la seconde région et
la séparation de la première et de la seconde région thermique au moyen i) d'une paroi de conduite(200) ; et ii) d'un solide enserrant le composant (120).

9. Procédé selon la revendication 8, comprenant en outre la mise en circulation d'un fluide dans la cavité entre le premier (110) et le second (130) trajet de chaleur.

10. Procédé selon la revendication 8, utilisant en outre un traitement de surface pour minimiser le transfert de chaleur entre les trajets de chaleur (110, 130).

11. Procédé selon la revendication 8, comprenant en outre la gestion de la température d'au moins une unité thermique (300, 301).
